# EUROPEAN PATENT APPLICATION

(11) **EP 4 418 832 A1**
(43) Date of publication of application: **21.08.2024**
(21) Application number: 22881124.6
(22) Date of filing: 14.10.2022
(51) Int. Cl.: H10K 30/50

(54) **PHOTOELECTRIC CONVERSION MATERIAL AND PHOTOELECTRIC CONVERSION ELEMENT USING SAME**

(30) Priority: 14.10.2021 JP 2021169163
(71) Applicant: Panasonic Intellectual Property Management Co., Ltd., Kadoma-shi, Osaka 571-0057 (JP)
(72) Inventor: OKUMURA, Hiroko, Kadoma-shi Osaka 571-0057 (JP)
(74) Representative: Grünecker Patent- und Rechtsanwälte PartG mbB
(86) International application number: PCT/JP2022/038486
(87) International publication number: WO 2023/063429

(57) **Abstract**

A photoelectric conversion material of the present disclosure includes a crystalline phase including A, B, X, and I. The A is a monovalent cation and includes a monovalent inorganic cation. The B is a divalent cation and includes Sn. The X is at least one selected from the group consisting of F, Cl, and Br. A molar ratio of a sum of the X and I to the B is 2.80 or more and 3.25 or less, and a molar ratio of the B to the A is more than 1.00 and 1.50 or less. A photoelectric conversion element of the present disclosure 100 includes: a first electrode 2; a photoelectric conversion layer 4; and a second electrode 6, and the photoelectric conversion layer 4 includes the photoelectric conversion material of the present disclosure.

## Description

### TECHNICAL FIELD

The present invention relates to a photoelectric conversion material and a photoelectric conversion element including the photoelectric conversion material.

### BACKGROUND ART

Non Patent Literature 1 discloses a solar cell including CsSnI₃ to which SnF₂ is added. Non Patent Literature 2 discloses a stable structure of a Sn-based perovskite compound including I.

### CITATION LIST

### Non Patent Literature

Non Patent Literature 1: Mulmudi H. Kumar and 13 others, Advanced Materials, September 2014, vol. 26, 41, pp. 7122-7127
Non Patent Literature 2: Weiyin Gao and eight others, "Robust Stability of Efficient Lead-Free Formamidinium Tin Iodide Perovskite Solar Cells Realized by Structural Regulation", J. Phys. Chem. Lett., 2018, 9, pp. 6999-7006
Non Patent Literature 3: R. D. SHANNON, "Revised Effective Ionic Radii and Systematic Studies of Interatomie Distances in Halides and Chaleogenides", Acta Cryst., 1976, A32, pp. 751-767
Non Patent Literature 4: Gregor Kieslich, Shijing Sun, and another, "Solid-state principles applied to organic-inorganic perovskites: new tricks for an old dog", Chem. Sci., 2014, 5, 4712-4715

### SUMMARY OF INVENTION

### Technical Problem

The present disclosure aims to enhance the photoelectric conversion efficiency of a photoelectric conversion material including Sn.

### Solution to Problem

A photoelectric conversion material of the present disclosure includes
a crystalline phase including A, B, X, and I, wherein
the A is a monovalent cation and includes a monovalent inorganic cation,
the B is a divalent cation and includes Sn,
the X is at least one selected from the group consisting of F, Cl, and Br,
a molar ratio of a sum of the X and I to the B is 2.80 or more and 3.25 or less, and
a molar ratio of the B to the A is more than 1.00 and 1.50 or less.

### Advantageous Effects of Invention

The present disclosure enhances the photoelectric conversion efficiency of a photoelectric conversion material including Sn.

### BRIEF DESCRIPTION OF DRAWINGS

FIG. 1 shows relations between Goldschmidt tolerance factors and ionic radii at the A site for CsSnI₃ and FASnI₃.
FIG. 2 is a cross-sectional view schematically showing the configuration of a photoelectric conversion element 100 of a second embodiment.
FIG. 3 is a graph showing I-V characteristics of photoelectric conversion elements of Examples 1 to 3 and Comparative Example 1.
FIG. 4 is a graph showing I-V characteristics of photoelectric conversion elements of Example 5 and Comparative Example 2.
FIG. 5 is a graph showing I-V characteristics of photoelectric conversion elements of Examples 6 to 11 and Reference Example.
FIG. 6 is a graph showing photoluminescence (PL) lifetimes of photoelectric conversion layers alone of Example 1 and Comparative Example 1.
FIG. 7 is a graph showing an X-ray diffraction pattern of CsSnI₃ being a photoelectric conversion material of Comparative Example 1.
FIG. 8 is a graph showing an X-ray diffraction pattern of a photoelectric conversion material of Example 1.
FIG. 9 is a graph showing an X-ray diffraction pattern of a photoelectric conversion material of Example 2.
FIG. 10 is a graph showing an X-ray diffraction pattern of CsSnI₃ being a photoelectric conversion material of Comparative Example 2.
FIG. 11 is a graph showing an X-ray diffraction pattern of a photoelectric conversion material of Example 4.
FIG. 12 is a graph showing an X-ray diffraction pattern of a photoelectric conversion material of Example 5.
FIG. 13A shows a crystal structure of a cubic crystal included in the photoelectric conversion material of the present disclosure.
FIG. 13B shows a crystal structure of an orthorhombic crystal included in the photoelectric conversion material of the present disclosure.
FIG. 13C shows a crystal structure of an orthorhombic crystal included in CsSnI₃.

### DESCRIPTION OF EMBODIMENTS

### [First embodiment]

The photoelectric conversion material of a first embodiment includes a crystalline phase including A, B, X, and I. The A is a monovalent cation and includes a monovalent inorganic cation. The B is a divalent cation and includes Sn. The X is at least one selected from the group consisting of F, Cl, and Br. A molar ratio of a sum of the X and I to the B is 2.80 or more and 3.25 or less. A molar ratio of the B to the A is more than 1.00 and 1.50 or less.

This configuration can enhance the photoelectric conversion efficiency of the photoelectric conversion material.

The molar ratio of the B to the A may be more than 1.00 and less than 1.30 to enhance the conversion efficiency of the photoelectric conversion material.

The molar ratio of the X to I may be 0.03 or more and 0.19 or less to enhance the conversion efficiency of the photoelectric conversion material.

In an X-ray diffraction pattern obtained by X-ray structure analysis of the crystalline phase included in the photoelectric conversion material of the first embodiment using a Cu-Kα ray, peaks may be present in diffraction angle 2θ ranges of 25.14° to 25.17° and 29.13° to 29.17°.

In the photoelectric conversion material of the first embodiment, the above crystalline phase may have a perovskite structure. That is, the photoelectric conversion material of the first embodiment may be a perovskite compound.

The perovskite compound refers to a perovskite crystal structure represented by a chemical formula ABX'₃ or a structure including a crystal similar thereto. The A is a monovalent cation, the B is a divalent cation, and the X' is a halogen anion.

In the photoelectric conversion material of the first embodiment, the monovalent cation represented by the A includes a monovalent inorganic cation. Examples of the monovalent inorganic cation include alkali metal cations. Examples of the alkali metal cations include a potassium cation (K⁺), a cesium cation (Cs⁺), and a rubidium cation (Rb⁺).

The monovalent cation represented by the A may further include a monovalent organic cation. In other words, in the photoelectric conversion material of the first embodiment, the A may include a monovalent inorganic cation and a monovalent organic cation. In this case, a proportion of an amount of substance of the monovalent inorganic cation to a sum of an amount of substance of the monovalent inorganic cation and an amount of substance of the monovalent organic cation may be, for example, 5 mol% or more and 30 mol% or less.

In the photoelectric conversion material of the first embodiment, the A may be the monovalent inorganic cation. That is, 100 mol% of the monovalent cation represented by the A may be the monovalent inorganic cation.

In the photoelectric conversion material of the first embodiment, the A may include Cs. The A may include 8 mol% or more Cs. The A may be Cs.

Examples of the monovalent organic cation include a methylammonium cation (namely, CH₃NH₃⁺) (CH₃NH₃ is hereinafter referred to as "MA"), a formamidinium cation (namely, NH₂CHNH₂⁺) (NH₂CHNH₂ is hereinafter referred to as "FA"), a phenylethylammonium cation (namely, C₆H₅C₂H₄NH₃⁺), and a guanidinium cation (namely, CH₆N₃⁺).

Examples of the divalent cation represented by the B include a lead cation (Pb²⁺), a tin cation (Sn²⁺), and a germanium cation (Ge²⁺). In the photoelectric conversion material of the first embodiment, the B includes at least Sn. The B may be Sn.

Each of the A and the B may include a plurality of cations.

In the photoelectric conversion material of the first embodiment, the X may include at least one selected from the group consisting of F and Cl. The X may be F or Cl.

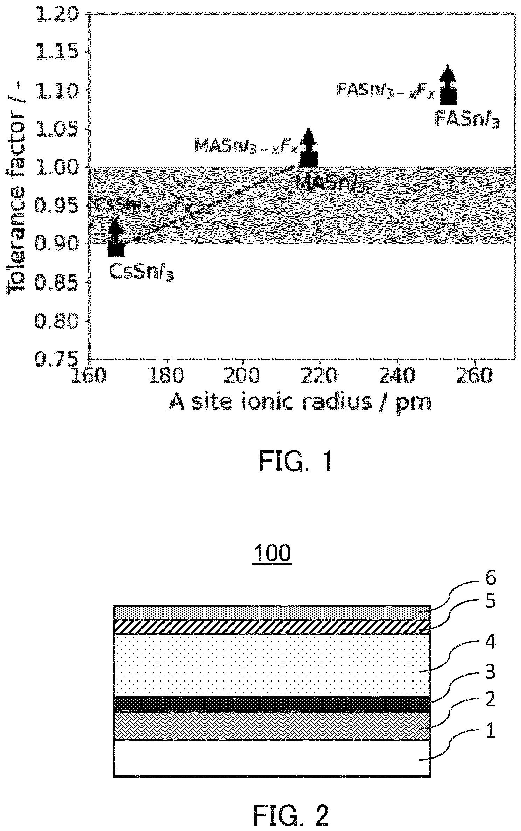

Since the A in the photoelectric conversion material of the first embodiment includes the monovalent inorganic cation, the photoelectric conversion material of the first embodiment can make Sn stable as a divalent cation by substituting F, Cl, or Br for part of I bonded to Sn while maintaining its thermodynamic stability. CsSnI₃ is hereinafter taken as an example for more detailed description. FIG. 1 shows relations between Goldschmidt tolerance factors and ionic radii at the A site for CsSnI₃, FASnI₃, and MASnI₃. According to Non Patent Literature 3, the ionic radius of I⁻ is 2.20 Å and that of Cs⁺ is 1.67 Å. The ionic radius of Sn²⁺ calculated from a result of XRD measurement carried out by the present inventor is 0.864 Å. From these values, the Goldschmidt tolerance of CsSnI₃ is 0.8932. In the case of CsSnI₃, substituting F for part of I can make the value of the Goldschmidt tolerance factor closer to an ideal range which is from 0.9 to 1, can enhance the thermodynamic stability, and can make Sn stable in the divalent state. On the other hand, in the case where the A site is an organic cation such as FA⁺ or MA⁺, the ionic radius of FA⁺ is 2.53 Å and that of MA⁺ is 2.17 Å according to Non Patent Literature 4; the organic cation at the A site is greater than Sn at the B site, and the Goldschmidt tolerance factor is more than 1. Specifically, the tolerance factor of FASnI₃ is 1.092, and the tolerance factor of MASnI₃ is 1.009. Therefore, in the case where the A site is an organic cation such as FA⁺ or MA⁺, substitution of F for I is not likely to occur because substitution of F for part of I would increase the Goldschmidt tolerance factor and results in destabilization. Moreover, while Sn in SnI₂ tends to become tetravalent by oxidation of SnI₂ in the air, SnF₂ is stable even in the air and Sn in SnF₂ is stable in the divalent state; it is therefore thought that substitution of F for part of I in CsSnI₃ improves the oxidation resistance too.

The photoelectric conversion material of the first embodiment can be manufactured, for example, by the following method.

First, a precursor solution of the photoelectric conversion material of the first embodiment is prepared. The precursor solution can be prepared by dissolving raw materials of the photoelectric conversion material in a solvent, for example, having a relatively high boiling point. The raw materials used for the preparation of the precursor solution of the photoelectric conversion material of the first embodiment are, for example, a compound, such as Csl, including the A and I, a compound, such as SnI₂, including the B and I, and a compound, such as SnF₂, including the B and the X. The solvent is, for example, a solvent containing dimethyl sulfoxide (DMSO; boiling point: 189°C) having a relatively high boiling point. The solvent may be a solvent mixture containing a plurality of solvents, or may be composed of one solvent. The precursor solution may be prepared, for example, by first preparing a first precursor solution and a second precursor solution and then mixing the first precursor solution and the second precursor solution, the first precursor solution containing: a compound including the A and I; a compound including the B and I; and the solvent, the second precursor solution containing: a compound including the B and the X; and the solvent. Next, the precursor solution prepared is applied to a base, for example, by a coating technique such as spin coating, and the resulting coating film is left to stand still for a given period of time for growth of a crystal nucleus in the coating film. After that, the coating film is baked, for example, at a relatively low temperature compared to the boiling point of the solvent. For example, in the case of using a solvent mixture containing dimethylformamide (DMF) and DMSO (at a volume ratio of 1:1), for example, the coating film may be baked at a temperature around 120°C after growth of a crystal nucleus in the coating film at room temperature.

On the other hand, as for the CsSnI₃ to which SnF₂ is added and that is disclosed in Non Patent Literature 1 described in BACKGROUND ART, a precursor solution containing CsSnI₃, SnF₂, and DMSO as a solvent is spin-coated to form a coating film, which is slowly crystallized at 70°C. A photoelectric conversion material of Non Patent Literature 1 produced by this method shows no XRD peak shift even when the SnF₂ concentration in the precursor solution is increased. This means that F⁻ has not substituted for I⁻ in the photoelectric conversion material of Non Patent Literature 1. In other words, the photoelectric conversion material described in Non Patent Literature 1 does not include a crystalline phase including the A, the B, the X, and I.

### [Second embodiment]

A photoelectric conversion element of a second embodiment will be described hereinafter. The features specified in the first embodiment may be omitted as appropriate.

The photoelectric conversion element of the second embodiment includes a first electrode, a photoelectric conversion layer, and a second electrode. The photoelectric conversion layer includes the photoelectric conversion material of the first embodiment. Hence, the photoelectric conversion element of the second embodiment has a high photoelectric conversion efficiency.

FIG. 2 is a cross-sectional view schematically showing the configuration of a photoelectric conversion element 100 of the second embodiment.

The photoelectric conversion element 100 according to the second embodiment includes, for example, a substrate 1, a first electrode 2, an electron transport layer 3, a photoelectric conversion layer 4, a hole transport layer 5, and a second electrode 6 in this order. The substrate 1, the electron transport layer 3, and the hole transport layer 5 may be omitted.

The photoelectric conversion layer 4 includes the photoelectric conversion material of the first embodiment.

Upon irradiation of the photoelectric conversion element 100 with light, the photoelectric conversion layer 4 absorbs the light and then charge separation into electrons and holes occurs. The electrons resulting from this charge separation transfer to the first electrode 2 through the electron transport layer 3. On the other hand, the holes formed in the photoelectric conversion layer 4 transfer to the second electrode 6 via the hole transport layer 5. The photoelectric conversion element 100 can thereby draw out an electric current from the first electrode 2 as a negative electrode and the second electrode 6 as a positive electrode.

The components of the photoelectric conversion element will be specifically described hereinafter.

### (Substrate 1)

The substrate 1 is an accessory component. The substrate 1 supports the layers in the photoelectric conversion element 100. The substrate 1 can be formed using a transparent material. A glass substrate or a plastic substrate, for example, can be used as the substrate 1. The plastic substrate may be, for example, a plastic film.

When the second electrode 6 has a light-transmitting property, the substrate 1 may be made of a material not having a light-transmitting property. As the material can be used a metal, a ceramic, or a resin material having a low light-transmitting property.

When the first electrode 2 is strong enough to support the layers, the substrate 1 may be omitted.

### (First electrode 2)

The first electrode 2 has electrical conductivity.

The first electrode 2 has a light-transmitting property. For example, the first electrode 2 allows visible to near-infrared light to pass therethrough.

The first electrode 2 is made of, for example, a material being transparent and having electrical conductivity. The material is, for example, a metal oxide or a metal nitride. The material is, for example,
(i) titanium oxide doped with at least one selected from the group consisting of lithium, magnesium, niobium, and fluorine,
(ii) gallium oxide doped with at least one selected from the group consisting of tin and silicon,
(iii) gallium nitride doped with at least one selected from the group consisting of silicon and oxygen,
(iv) tin oxide doped with at least one selected from the group consisting of antimony and fluorine,
(v) zinc oxide doped with at least one selected from the group consisting of boron, aluminum, gallium, and indium,
(vi) indium-tin composite oxide, or
(vii) a composite thereof.

The first electrode 2 may be formed to have a pattern that allows light to pass therethrough. The pattern that allows light to pass therethrough is, for example, a linear pattern, a wave line pattern, a lattice pattern, or a perforated-metal-like pattern where a lot of small through holes are regularly or irregularly arranged. When the first electrode 2 has any of these patterns, light can pass through portions without the electrode material. Thus, a non-transparent material can be used for the first electrode 2 having the pattern that allows light to pass therethrough. Examples of the non-transparent electrode material include platinum, gold, silver, copper, aluminum, rhodium, indium, titanium, iron, nickel, tin, zinc, or an alloy including any of these. An electrically conductive carbon material may be used as the non-transparent electrode material.

The light-transmitting property of the first electrode 2 is not necessarily achieved by the above-described pattern that allows light to pass therethrough. For example, the first electrode 2 may be formed as a thin metal film having a thickness of approximately 10 nm. The thin metal film is made of, for example, platinum, gold, silver, copper, aluminum, rhodium, indium, titanium, iron, nickel, tin, zinc, or an alloy including any of these. An electrically conductive carbon material may be used in place of these metal materials.

In the case where the photoelectric conversion element 100 does not include the electron transport layer 3, the first electrode 2 has a property of blocking holes from the photoelectric conversion layer 4. In this case, the first electrode 2 is not in ohmic contact with the photoelectric conversion layer 4. The property of blocking holes from the photoelectric conversion layer 4 is a property of allowing only electrons formed in the photoelectric conversion layer 4 to pass and not allowing holes to pass. The Fermi energy of a material having such a property is higher than the energy of the photoelectric conversion layer 4 at an upper part of the valence band. The Fermi energy of a material having such a property may be higher than the Fermi energy of the photoelectric conversion layer 4. The material is specifically aluminum.

In the case where the photoelectric conversion element 100 includes the electron transport layer 3, the first electrode 2 does not necessarily have the property of blocking holes from the photoelectric conversion layer 4. In this case, the first electrode 2 can include a material capable of forming an ohmic contact with the photoelectric conversion layer 4. In this case, the first electrode 2 may be in ohmic contact with the photoelectric conversion layer 4, or is not necessarily in ohmic contact with the photoelectric conversion layer 4.

The transmittance of the first electrode 2 may be, for example, 50% or more, or 80% or more. The wavelength of light that is to pass through the first electrode 2 depends on the absorption wavelength of the photoelectric conversion layer 4.

The thickness of the first electrode 2 may be, for example, 1 nm or more and 1000 nm or less.

### (Electron transport layer 3)

The electron transport layer 3 includes a semiconductor. The electron transport layer 3 may be made of a semiconductor having a band gap of 3.0 eV or more. In this case, visible light and infrared light are allowed to pass therethrough to the photoelectric conversion layer 4. The semiconductor is, for example, an inorganic n-type semiconductor.

Examples of the inorganic n-type semiconductor include a metal oxide, a metal nitride, and a perovskite oxide. The metal oxide is, for example, an oxide of Cd, Zn, In, Pb, Mo, W, Sb, Bi, Cu, Hg, Ti, Ag, Mn, Fe, V, Sn, Zr, Sr, Ga, Si, or Cr. The metal oxide is, for example, TiO₂ or SnO₂. The metal nitride is, for example, GaN. The perovskite oxide is, for example, SrTiOs or CaTiOs.

The electron transport layer 3 may include a semiconductor having a band gap of 6.0 eV or more to effectively allow, in particular, ultraviolet to pass therethrough to the photoelectric conversion layer 4. Examples of the semiconductor include halides, such as lithium fluoride and calcium fluoride, of alkali metals and alkaline earth metals, alkali metal oxides such as magnesium oxide, and silicon dioxide. In this case, the electron transport layer 3 may have a thickness of, for example, 10 nm or less to secure the electron transport capability of the electron transport layer 3.

The electron transport layer 3 may include a plurality of layers made of different materials.

### (Photoelectric conversion layer 4)

The photoelectric conversion layer 4 includes the photoelectric conversion material of the first embodiment.

The photoelectric conversion layer 4 may include the photoelectric conversion material of the first embodiment as its main component. Saying that "the photoelectric conversion layer 4 includes the photoelectric conversion material of the first embodiment as its main component" means that the photoelectric conversion material of the first embodiment accounts for 50 mass% or more of the photoelectric conversion layer 4. The photoelectric conversion material of the first embodiment may account for 70 mass% or more of the photoelectric conversion layer 4. The photoelectric conversion material of the first embodiment may account for 90 mass% or more of the photoelectric conversion layer 4. The photoelectric conversion layer 4 may consist of the photoelectric conversion material of the first embodiment. The photoelectric conversion layer 4 needs to include the photoelectric conversion material of the first embodiment, and may include a defect or an impurity.

The photoelectric conversion layer 4 may also include a photoelectric conversion material different from the photoelectric conversion material of the first embodiment.

The thickness of the photoelectric conversion layer 4 is, for example, 50 nm or more and 10 µm or less.

The photoelectric conversion layer 4 can be formed by a coating technique involving a solution, a printing technique, or a deposition technique. Examples of the coating technique include doctor blade coating, bar coating, spraying, dip coating, inkjet coating, slit coating (namely, die coating), and spin coating.

### (Hole transport layer 5)

The hole transport layer 5 includes a hole transport material. The hole transport material is a material that transports a hole. The hole transport material is, for example, an organic semiconductor or an inorganic semiconductor.

Examples of the organic semiconductor include triphenylamine, triallylamine, phenylbenzidine, phenylenevinylene, tetrathiafulvalene, vinylnaphthalene, vinylcarbazole, thiophene, aniline, pyrrole, carbazole, triptycene, fluorene, azulene, pyrene, pentacene, perylene, acridine, and phthalocyanine.

Typical examples of the organic semiconductor used as the hole transport material include 2,2',7,7'-tetrakis-(N,N-di-p-methoxyphenylamine)9,9'-spirobifluorene, poly[bis(4-phenyl)(2,4,6-trimethylphenyl)amine] (which may be referred to as "PTAA" hereinafter), poly(3-hexylthiophene-2,5-diyl), poly(3,4-ethylenedioxythiophene), and copper phthalocyanine.

The inorganic semiconductor used as the hole transport material is a p-type semiconductor. Examples of the inorganic semiconductor include Cu₂O, CuGaO₂, CuSCN, Cui, NiOₓ, MoOₓ, V₂O₅, and a carbon material such as graphene oxide. Here, x satisfies x > 0.

The hole transport layer 5 may include a plurality of layers made of different materials. For example, hole transport properties of the hole transport layer 5 are improved by stacking the plurality of layers whose ionization potentials are smaller than that of the photoelectric conversion layer 4 such that the ionization potentials decrease layer by layer.

The thickness of the hole transport layer 5 may be 1 nm or more and 1000 nm or less, or 10 nm or more and 50 nm or less. This allows the hole transport layer 5 to exhibit sufficiently high hole transport properties. Consequently, the resistance of the photoelectric conversion element 100 can be maintained at a low level, and a high photoelectric conversion efficiency can be achieved.

The hole transport layer 5 is formed, for example, by a coating technique, a printing technique, or a deposition technique. The same can be said to the photoelectric conversion layer 4. Examples of the coating technique include doctor blade coating, bar coating, spraying, dip coating, inkjet coating, slit coating (namely, die coating), and spin coating. Examples of the printing technique include screen printing. If needed, the hole transport layer 5 may be formed using a mixture of a plurality of materials and then compressed or baked. In the case that the material of the hole transport layer 5 is a low-molecular-weight organic substance or an inorganic semiconductor, the hole transport layer 5 can be produced by vacuum deposition.

The hole transport layer 5 may include not only the hole transport material but an additive to increase the electrical conductivity. Examples of the additive include a supporting electrolyte, a solvent, and a dopant. The supporting electrolyte and the solvent stabilize holes in the hole transport layer 5. The dopant increases the number of holes in the hole transport layer 5.

Examples of the supporting electrolyte include an ammonium salt, an alkaline earth metal salt, and a transition metal salt. Examples of the ammonium salt include tetrabutylammonium perchlorate, tetraethylammonium hexafluorophosphate, an imidazolium salt, and a pyridinium salt. Examples of the alkali metal salt include lithium perchlorate and potassium tetrafluoroborate. Examples of the alkaline earth metal salt include lithium bis(trifluoromethanesulfonyl)imide and calcium(II) bis(trifluoromethanesulfonyl)imide. Examples of the transition metal salt include zinc(II) bis(trifluoromethanesulfonyl)imide and tris[4-tert-butyl-2-(1H-pyrazole-1-yl)pyridine]cobalt(III) tris(trifluoromethanesulfonyl)imide.

Examples of the dopant include a fluorine-containing aromatic boron compound. Examples of the fluorine-containing aromatic boron compound include tris(pentafluorophenyl)borane.

The solvent included in the hole transport layer 5 may have excellent ion conductivity. The solvent may be an aqueous solvent or an organic solvent. To make the solute more stable, the solvent included in the hole transport layer 5 may be an organic solvent. Examples of the organic solvent include heterocyclic compound solvents such as tert-butylpyridine, pyridine, and n-methylpyrrolidone.

An ionic liquid may be used as the solvent. The ionic liquid may be used alone, or may be used after mixed with a different solvent. The ionic liquid is desirable for its low volatility and high flame retardancy.

Examples of the ionic liquid include imidazolium ionic liquids such as 1-ethyl-3-methylimidazolium tetracyano borate, pyridine ionic liquids, alicyclic amine ionic liquids, aliphatic amine ionic liquids, and azonium amine ionic liquids.

### (Second electrode 6)

The second electrode 6 has electrical conductivity.

In the case where the photoelectric conversion element 100 does not include the hole transport layer 5, the second electrode 6 has a property of blocking electrons from the photoelectric conversion layer 4. In this case, the second electrode 6 is not in ohmic contact with the photoelectric conversion layer 4. The property of blocking electrons from the photoelectric conversion layer 4 refers to a property of allowing only holes formed in the photoelectric conversion layer 4 to pass and not allowing electrons to pass. The Fermi energy of a material having such a property is lower than the energy of the photoelectric conversion layer 4 at a lower part of the conduction band. The Fermi energy of a material having such a property may be lower than the Fermi energy of the photoelectric conversion layer 4. The material is specifically platinum, gold, or a carbon material such as graphene.

In the case where the photoelectric conversion element 100 includes the hole transport layer 5, the second electrode 6 does not necessarily have the property of blocking electrons from the photoelectric conversion layer 4. In this case, the second electrode 6 can include a material capable of forming an ohmic contact with the photoelectric conversion layer 4. Therefore, the second electrode 6 can be formed to have a light-transmitting property.

An electrode that is the first electrode 2 or the second electrode 6 and that is configured to allow light to be incident thereon needs to have a light-transmitting property. That is, one of the first electrode 2 and the second electrode 6 does not necessarily have a light-transmitting property. That is, one of the first electrode 2 and the second electrode 6 does not necessarily include a material having a light-transmitting property, or does not necessarily have a pattern including an opening portion that allows light to pass therethrough.

### (Porous layer)

A porous layer is formed on the electron transport layer 3, for example, by a coating technique. In the case that the photoelectric conversion element 100 does not include the electron transport layer 3, the porous layer is formed on the first electrode 2.

A pore structure provided by the porous layer serves as a foundation at the time of formation of the photoelectric conversion layer 4. The porous layer does not prevent light absorption by the photoelectric conversion layer 4 and electron transfer from the photoelectric conversion layer 4 to the electron transport layer 3.

The porous layer includes a porous body.

The porous body is made of, for example, continuous insulating particles or continuous semiconductor particles. The insulating particles are, for example, aluminum oxide particles or silicon oxide particles. The semiconductor particles are, for example, inorganic semiconductor particles. The inorganic semiconductor is, for example, a metal oxide, a perovskite oxide of a metal element, a sulfide of a metal element, or a metal chalcogenide. The metal oxide is, for example, an oxide of Cd, Zn, In, Pb, Mo, W, Sb, Bi, Cu, Hg, Ti, Ag, Mn, Fe, V, Sn, Zr, Sr, Ga, Si, or Cr. The metal oxide is, for example, TiO₂. The perovskite oxide of a metal element is, for example, SrTiOs or CaTiOs. The sulfide of a metal element is, for example, CdS, ZnS, In₂S₃, PbS, Mo₂S, WS₂, Sb₂S₃, Bi₂S₃, ZnCdS₂, or Cu₂S. The metal chalcogenide is, for example, CsSe, In₂Se₃, WSe₂, HgS, PbSe, or CdTe.

The thickness of the porous layer may be 0.01 µm or more and 10 µm or less, or 0.05 µm or more and 1 µm or less.

Regarding surface roughness of the porous layer, a surface roughness factor determined by "effective area/projected area" may be 10 or greater, or 100 or greater. The projected area refers to the area of a shadow behind an object irradiated with light from the front. The effective area refers to the actual surface area of an object. The effective area can be calculated from a volume of an object, the specific surface area of the material of the object, and the bulk density of the material of the object, the volume being determined from the projected area and the thickness of the object. The specific surface area is measured, for example, by a nitrogen adsorption method.

A void in the porous layer is continuous from one principal surface of the porous layer to the other principal surface. That is, a void in the porous layer is continuous from a principal surface of the porous layer in contact with the photoelectric conversion layer 4 to a principal surface of the porous layer in contact with the electron transport layer 3. This allows the material of the photoelectric conversion layer 4 to fill the void of the porous layer and reach the surface of the electron transport layer 3. The photoelectric conversion layer 4 and the electron transport layer 3 are thus in direct contact to each other and therefore can give and receive electrons therebetween.

Inclusion of the porous layer makes it easy to form the photoelectric conversion layer 4. When the porous layer is included, the material of the photoelectric conversion layer 4 enters the void of the porous layer and the porous layer serves as a foothold for the photoelectric conversion layer 4. This makes it unlikely that the material of the photoelectric conversion layer 4 is repelled by the surface of the porous layer or aggregates on the surface of the porous layer. Consequently, the photoelectric conversion layer 4 can be easily formed as a uniform film. The photoelectric conversion layer 4 can be formed by the above coating technique, the above printing technique, the above deposition technique, or the like.

It is thought that the porous layer increases the contact area between the perovskite layer and the electron transport layer and the increase is advantageous in terms of electron transport and current collection.

### [Other embodiments]

### (Supplement)

The description of the above embodiments discloses the following techniques.

### (Technique 1)

A photoelectric conversion material including
a crystalline phase including A, B, X, and I, wherein
the A is a monovalent cation and includes a monovalent inorganic cation,
the B is a divalent cation and includes Sn,
the X is at least one selected from the group consisting of F, Cl, and Br,
a molar ratio of a sum of the X and I to the B is 2.80 or more and 3.25 or less, and
a molar ratio of the B to the A is more than 1.00 and 1.50 or less.

This configuration can enhance the photoelectric conversion efficiency of the photoelectric conversion material.

### (Technique 2)

The photoelectric conversion material according to the technique 1, wherein the molar ratio of the B to the A is more than 1.00 and less than 1.30.

This configuration can further enhance the photoelectric conversion efficiency of the photoelectric conversion material.

### (Technique 3)

The photoelectric conversion material according to the technique 1 or 2, wherein a molar ratio of the X to I is 0.03 or more and 0.19 or less.

This configuration can further enhance the photoelectric conversion efficiency of the photoelectric conversion material.

### (Technique 4)

The photoelectric conversion material according to any one of the techniques 1 to 3, wherein in an X-ray diffraction pattern obtained by X-ray structure analysis of the crystalline phase using a Cu-Kα ray, peaks are present in diffraction angle 2θ ranges of 25.14° to 25.17° and 29.13° to 29.17°.

This configuration can further enhance the photoelectric conversion efficiency of the photoelectric conversion material.

### (Technique 5)

The photoelectric conversion material according to any one of the techniques 1 to 4, wherein the crystalline phase has a perovskite structure.

This configuration can further enhance the photoelectric conversion efficiency of the photoelectric conversion material.

### (Technique 6)

The photoelectric conversion material according to any one of the techniques 1 to 5, wherein
the A further includes a monovalent organic cation, and
a proportion of an amount of substance of the monovalent inorganic cation to a sum of an amount of substance of the monovalent inorganic cation and an amount of substance of the monovalent organic cation is 5 mol% or more and 30 mol% or less.

This configuration can enhance the stability of the photoelectric conversion material.

### (Technique 7)

The photoelectric conversion material according to any one of the techniques 1 to 5, wherein the A is the monovalent inorganic cation.

This configuration can enhance the stability of the photoelectric conversion material.

### (Technique 8)

The photoelectric conversion material according to any one of the techniques 1 to 7, wherein the monovalent inorganic cation includes Cs.

This configuration can further enhance the photoelectric conversion efficiency of the photoelectric conversion material.

### (Technique 9)

The photoelectric conversion material according to any one of the techniques 1 to 8, wherein the X includes at least one selected from the group consisting of F and Cl.

This configuration can further enhance the photoelectric conversion efficiency of the photoelectric conversion material.

### (Technique 10)

A photoelectric conversion element including:
a first electrode;
a photoelectric conversion layer; and
a second electrode, wherein
the photoelectric conversion layer includes the photoelectric conversion material according to any one of the techniques 1 to 9.

This configuration can provide a photoelectric conversion element having an enhanced photoelectric conversion efficiency.

### EXAMPLES

The present disclosure will be described hereinafter in more details with reference to examples.

Hereinafter, preparation of raw material solutions of photoelectric conversion layers and hole transport layers and formation of photoelectric conversion layers and hole transport layers were carried out in a glove box in which the oxygen concentration and the moisture concentration were each 1 ppm or lower.

### <Production of photoelectric conversion element (regular): Examples 1 to 3 and Comparative Example 1>

First, a glass substrate was prepared. The substrate plays the role of a supporting material for the photoelectric conversion element of the present disclosure.

An indium tin oxide (ITO) layer and an antimony tin oxide (ATO) layer were formed in this order on the substrate by sputtering. A first electrode was formed in this manner.

Next, a compact titanium oxide (TiO₂) layer was formed on the ATO layer by sputtering. This compact titanium oxide (TiO₂) layer corresponds, for example, to the electron transport layer described in the above first embodiment.

Next, 0.3 g of a titanium oxide paste 30NR-D (manufactured by Gratcell Solar Materials Pty Ltd.) was dissolved in 2 mL of a butanol solution. The resulting solution was applied to the electron transport layer by spin coating, followed by baking at 500°C for 30 minutes. A porous titanium oxide layer was formed in this manner. The spin coating was performed at 4000 rpm for 20 seconds. It should be noted that both the above compact titanium oxide (TiO₂) layer and the above porous titanium oxide layer have an electron transport capability. Therefore, it can be considered that the electron transport layer is composed of the above compact titanium oxide (TiO₂) layer and the above porous titanium oxide layer.

A precursor solution of a photoelectric conversion layer was applied to the porous layer by spin coating, left to stand still at room temperature for 10 minutes, and then baked at 120°C for 30 minutes. A photoelectric conversion layer was formed in this manner. The spin coating was performed at 5000 rpm for 30 seconds while chlorobenzene being a poor solvent was supplied dropwise.

The precursor solution of the photoelectric conversion layer was obtained in the following manner. First, SnI₂ and Csl were added to a solution mixture containing DMF and DMSO (at a volume ratio of 1:1) to prepare a 0.8 M first solution. Next, SnF₂ was added to a solution mixture containing DMF and DMSO (at a volume ratio of 1:1) to prepare a 0.8 M second solution. The second solution was added to the first solution. The precursor solution was obtained in this manner.

For Examples, three types of the precursor solution were prepared. The precursor solutions, for which the amount of the second solution added was respectively 15 mol%, 20 mol%, and 25 mol%, were respectively for Examples 1, 2, and 3. For Comparative Example 1, the second solution was not added and only the first solution was used as the precursor solution of the photoelectric conversion layer.

Next, a raw material solution of a hole transport layer was applied to the photoelectric conversion layer by spin coating. A hole transport layer was formed in this manner. The raw material solution of the hole transport layer was prepared by dissolving 18 mg of poly[bis(4-phenyl)(2,4,6-triphenyl)amine] (PTAA) in 1 mL of chlorobenzene. The spin coating was performed at 4000 rpm for 20 seconds.

Then, a gold film was formed on the hole transport layer by deposition. A 200 nm-thick second electrode was formed in this manner.

Finally, a UV-curable epoxy resin was applied to a periphery of the substrate, another glass substrate was placed thereon, and the resulting laminate was irradiated with UV. The epoxy resin was thereby cured to encapsulate the electricity generation constituents.

### <Production of photoelectric conversion element (inverted): Example 4, Example 5, and Comparative Example 2>

First, a glass substrate was prepared. The substrate plays the role of a supporting material for a solar cell of the present disclosure.

An ITO layer was formed on the substrate by sputtering. A first electrode was formed in this manner.

Next, an aqueous PEDOTPSS solution (manufactured by Heraeus) was applied to the first electrode by spin coating to form a hole transport layer. The spin coating was performed at 4000 rpm.

A precursor solution of a photoelectric conversion layer was applied to the hole transport layer by spin coating, left to stand still at room temperature for 10 minutes, and then baked at 120°C for 30 minutes. A photoelectric conversion layer was formed in this manner. The spin coating was performed at 2500 rpm for 30 seconds.

The precursor solution of the photoelectric conversion layer was obtained in the following manner. First, SnI₂ and Csl were added to a solution mixture containing DMF and DMSO (at a volume ratio of 1:1) to prepare a 0.8 M first solution. Next, SnCl₂ was added to a solution mixture containing DMF and DMSO (at a volume ratio of 1:1) to prepare a 0.8 M second solution. The second solution in an amount of 5 mol% or 10 mol% was added to the first solution. Precursor solutions of photoelectric conversion layers of Examples 4 and 5 were obtained in this manner. For Comparative Example 2, the second solution was not added and only the first solution was used as the precursor solution of the photoelectric conversion layer.

A solution obtained by dissolving 20 mg of phenyl C₆₁ butyric acid methyl ester (PCBM) in 1 mL of chlorobenzene was applied to the photoelectric conversion layer by spin coating at 4000 rpm for 20 seconds.

Subsequently, a bathocuproine (BCP) film was formed by deposition. A 6 nm-thick electron injection layer was formed in this manner.

Next, a silver film was formed by deposition. A 200 nm-thick second electrode was formed in this manner.

Finally, a UV-curable epoxy resin was applied to a periphery of the substrate, another glass substrate was placed thereon, and the resulting laminate was irradiated with UV. The epoxy resin was thereby cured to encapsulate the electricity generation constituents.

### <Production of photoelectric conversion element (regular): Examples 6 to 11 and Reference Example>

Photoelectric conversion elements were produced in the same manner as in Examples 1 to 3 and Comparative Example 1 except for the precursor solutions of the photoelectric conversion layers.

The precursor solutions of the photoelectric conversion layers were obtained in the following manner. First, by adding SnI₂, MAI, and Csl to a solution mixture containing DMF and DMSO (at a volume ratio of 1:1), seven types of 0.8 M first solution in which a molar ratio (CsI:MAI) between Csl and MAI was respectively 100:0, 5:95, 10:90, 20:80, 30:70, 50:50, and 0:100 were prepared. Next, SnF₂ was added to a solution mixture containing DMF and DMSO (at a volume ratio of 1:1) to prepare a 0.8 M second solution. The second solution in an amount of 15 mol% was added to each first solution. The precursor solutions were obtained in this manner.

### <Evaluation of characteristic of photoelectric conversion element>

I-V characteristics were evaluated for the photoelectric conversion elements of Examples and Comparative Examples.

A solar simulator (manufactured by Bunkoukeiki Co., Ltd.) and an electrochemical analyzer ALS (manufactured by BAS Inc.) were used for the evaluation of the characteristics. Each photoelectric conversion element was irradiated with one sun of simulated sunlight. The output of the solar simulator was set to 100 mW/cm². Current-voltage characteristics (namely, I-V characteristics) of the photoelectric conversion elements were measured by measuring output current values using the electrochemical analyzer under varying applied voltage.

Tables 1 and 2 show the measurement results. The symbol η represents the conversion efficiency. The symbol Jsc represents the short-circuit current density. The symbol V_{oc} represents the open-circuit voltage. The symbol FF represents the fill-factor. Table 1 also shows a molar ratio ((X + I)/B) of the sum of X and I to B and a molar ratio (B/A) of B to A in each photoelectric conversion material. Ratios based on the amounts of the components actually added represent these molar ratios. It should be noted that the above molar ratios in the photoelectric conversion materials produced by the methods in EXAMPLES were substantially equal to molar ratios based on the ratios between the amounts of the components actually added.

**[Table 1]**

| | Amount of SnF₂ or SnCl₂ added (mol%) | (X + I)/B | B/A | η (%) | J_{SC} (mA/cm²) | V_{oc} (V) | FF |
|---|---|---|---|---|---|---|---|
| Example 1 | 15 | 2.87 | 1.15 | 2.15 | 24.000 | 0.196 | 0.457 |
| Example 2 | 20 | 2.83 | 1.20 | 2.15 | 23.660 | 0.192 | 0.473 |
| Example 3 | 25 | 2.80 | 1.25 | 1.42 | 17.190 | 0.187 | 0.441 |
| Comparative Example 1 | 0 | 3.00 | 1.00 | 0.00 | 3.174 | 0.011 | 0.000 |
| Example 5 | 10 | 2.91 | 1.10 | 0.29 | 7.865 | 0.109 | 0.337 |
| Comparative Example 2 | 0 | 3.00 | 1.00 | 0.00 | -1.999 | -0.002 | 0.000 |

**[Table 2]**

| | Molar ratio between CsI and MAl (CsI:MAI) | η (%) | J_{SC} (mA/cm²) | V_{oc} (V) | FF |
|---|---|---|---|---|---|
| Example 6 | 100:0 | 1.32 | 21.730 | 0.178 | 0.341 |
| Example 7 | 5:95 | 1.50 | 22.650 | 0.169 | 0.393 |
| Example 8 | 10:90 | 1.48 | 22.620 | 0.169 | 0.388 |
| Example 9 | 20:80 | 1.91 | 23.980 | 0.178 | 0.446 |
| Example 10 | 30:70 | 1.54 | 23.240 | 0.175 | 0.379 |
| Example 11 | 50:50 | 1.08 | 20.280 | 0.165 | 0.322 |
| Reference Example | 0:100 | 0.61 | 17.770 | 0.103 | 0.336 |

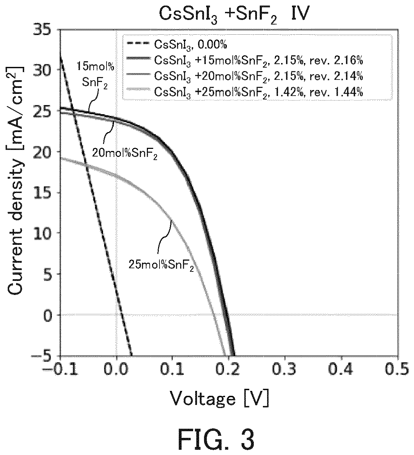

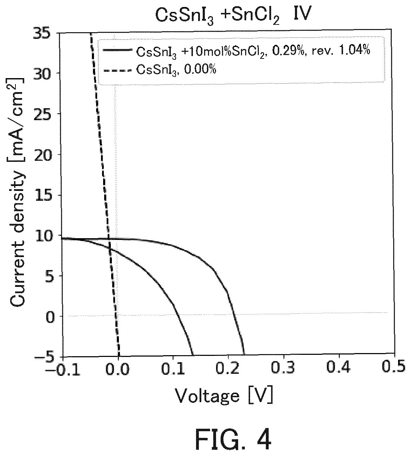

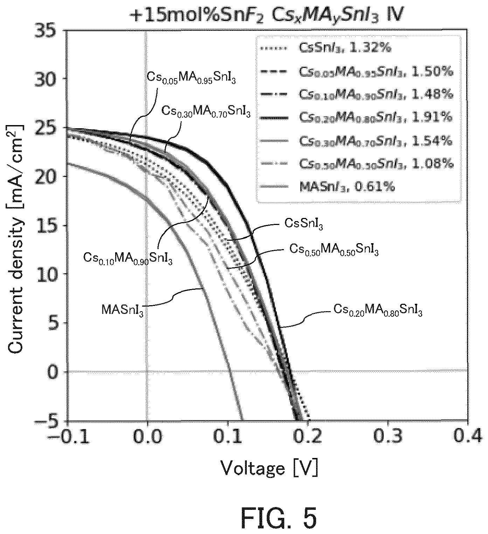

FIG. 3 is a graph showing I-V characteristics of the photoelectric conversion elements of Examples 1 to 3 and Comparative Example 1. FIG. 4 is a graph showing I-V characteristics of the photoelectric conversion elements of Example 5 and Comparative Example 2. FIG. 5 is a graph showing I-V characteristics of the photoelectric conversion elements of Examples 6 to 11 and Reference Example. In FIGS. 3 to 5, the horizontal axis represents the applied voltage, and the vertical axis represents the current density. FIG. 4 shows two I-V curves of the photoelectric conversion element of Example 5. These are an I-V curve obtained by sweeping from the high voltage side (forward sweep) and an I-V curve obtained by sweeping from the low voltage side (backward sweep). The conversion efficiency is better in the case of sweeping from the low voltage side. Table 1 shows the results obtained from Example 5 by sweeping from the high voltage side.

The results shown in Table 1, FIG. 3, and FIG. 4 have revealed that, compared to the photoelectric conversion element of Comparative Example 1, the photoelectric conversion elements of Examples 1 to 3 have an improved rectifying function in the devices and enhanced photoelectric conversion efficiencies. Moreover, it has also been revealed that, compared to the photoelectric conversion element of Comparative Example 2, the photoelectric conversion element of Example 5 has a rectifying function in the device and an enhanced photoelectric conversion efficiency.

According to FIG. 1, substitution of F for part of I in ASnI₃ (where A is Cs, MA, or FA) increases the Goldschmidt tolerance factor. Moreover, the Goldschmidt tolerance factor of CsSnI₃ to which 15 mol% SnF₂ was added is 0.8933 while that of MASnI₃ is 1.009; this fact suggests that it is good that a blending ratio of MA⁺ to Cs⁺ is adjusted and F is substituted for part of I so that the Goldschmidt tolerance factor will stay within the ideal value range, namely 0.9 to 1.0.

The photoelectric conversion elements of Examples 6 to 11 include photoelectric conversion layers including photoelectric conversion materials including the A, the B, the X, and I, where the A is a monovalent inorganic cation (here, the A is Cs⁺). On the other hand, in the photoelectric conversion element of Reference Example, the A in the photoelectric conversion material consists of a monovalent organic cation (here, the A is MA⁺). According to the results shown in Table 2 and FIG. 5, the photoelectric conversion elements of Examples 6 to 11 have higher high photoelectric conversion efficiencies than that of the photoelectric conversion element of Reference Example. Additionally, the photoelectric conversion elements of Examples 7 to 10 where the proportion of the amount of substance of Cs⁺ to the sum of the amount of substance of Cs⁺ and that of MA⁺ is in the range of 5 mol% or more and 30 mol% or less have much higher photoelectric conversion efficiencies. The photoelectric conversion efficiency is highest when, specifically, a molar ratio between Cs⁺ and MA⁺ (Cs⁺:MA⁺) in the perovskite crystal is 20:80. The photoelectric conversion element of Example 6 was produced, as described above, in the same manner as for the photoelectric conversion element of Example 1. Therefore, theoretically, the photoelectric conversion element of Example 6 is supposed to exhibit the same performance as the photoelectric conversion element of Example 1. Actually, however, as shown in Tables 1 and 2, the photoelectric conversion efficiency of the photoelectric conversion element of Example 6 is lower than the photoelectric conversion efficiency of the photoelectric conversion element of Example 1. This is presumably due to different oxygen and hydrogen concentrations in the manufacturing atmospheres in the manufacturing apparatuses. It is thought that preparation for adjustment of the oxygen and hydrogen concentrations in the manufacturing atmosphere in the manufacturing apparatus was not as sufficient for Example 6 as for Example 1 and that resulted in the lower performance of Example 6 than of Example 1. Incidentally, the photoelectric conversion elements of Example 7 to 11 and Reference Example were manufactured using the same apparatus as Example 6 under the same manufacturing atmosphere (namely, at the same oxygen concentration and the same hydrogen concentration) as Example 6; therefore, evaluation comparison between the performances of the photoelectric conversion elements of Example 6 to 11 and Reference Example is reasonable.

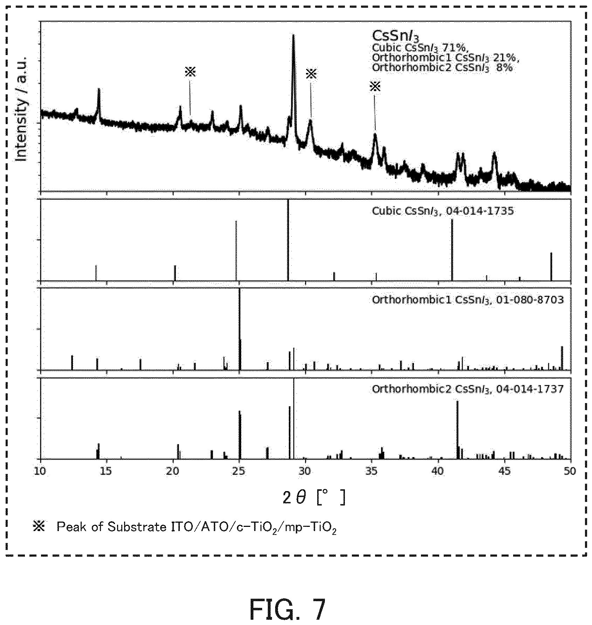

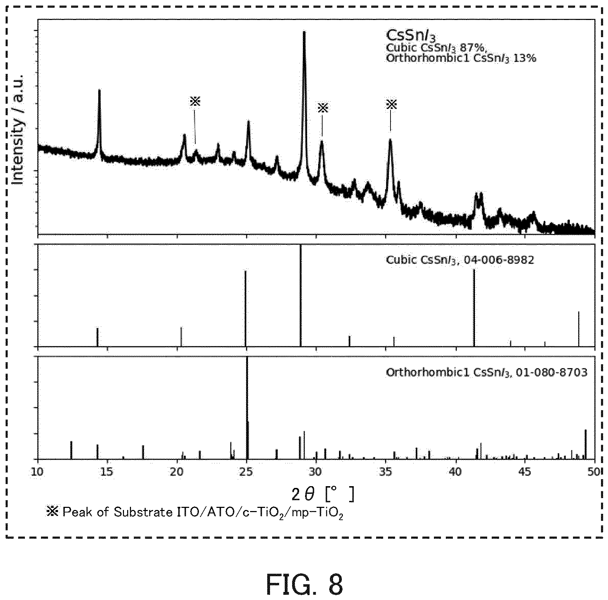

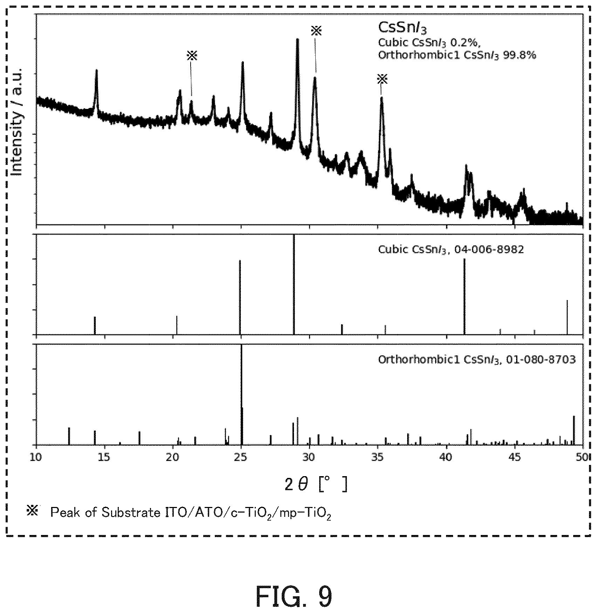

X-ray diffraction measurement was performed for the photoelectric conversion layers of Example 1, Example 2, and Comparative Example 1 using a Cu-Kα ray. A fully automatic multifunctional X-ray diffractometer SmartLab (manufactured by Rigaku Corporation) was used for the X-ray diffraction measurement. Crystal structures were identified by the RIR method using PDXL, the software installed in the X-ray diffractometer. Tables 3 and 4 show the results. Table 3 shows peak positions in X-ray diffraction patterns. The column "No." in Table 3 shows numbers given to the peaks detected by X-ray diffraction in ascending order of angle. The column "PDF card No." in Table 4 shows data numbers of the crystal structures of the identified space groups. Table 4 also shows lattice constants of the analyzed crystals. Additionally, FIG. 7 is a graph showing the X-ray diffraction pattern of CsSnI₃ being the photoelectric conversion material of Comparative Example 1. FIG. 8 is a graph showing the X-ray diffraction pattern of the photoelectric conversion material of Example 1. FIG. 9 is a graph showing the X-ray diffraction pattern of the photoelectric conversion material of Example 2.

**[Table 3]**

| No. | Comparative Example 1 CsSnI₃ [2θ (deg)] | Example 1 CsSnI₃ + 15 mol% SnF₂ [2θ (deg)] | Example 2 CsSnI₃ + 20 mol% SnF₂ [2θ (deg)] |
|---|---|---|---|
| 1 | 14.455 | 14.463 | 14.455 |
| 2 | 20.571 | 20.551 | 20.560 |
| 3 | 22.989 | 21.35 | 21.40 |
| 4 | 24.10 | 23.001 | 23.001 |
| 5 | 25.139 | 25.160 | 24.119 |
| 6 | 25.66 | 27.193 | 25.149 |
| 7 | 27.19 | 29.1517 | 27.179 |
| 8 | 28.757 | 30.384 | 29.142 |
| 9 | 29.1229 | 32.75 | 30.366 |
| 10 | 30.357 | 33.71 | 33.71 |
| 11 | 33.58 | 35.315 | 35.307 |
| 12 | 35.251 | 35.931 | 35.949 |
| 13 | 35.941 | 37.495 | 37.47 |
| 14 | 37.49 | 41.61 | 41.48 |
| 15 | 41.470 | 43.09 | 41.793 |
| 16 | 44.284 | 45.48 | 43.11 |
| 17 | 45.74 | 50.78 | 45.46 |
| 18 | 50.68 | 51.65 | 50.752 |
| 19 | 60.419 | 60.450 | 51.61 |
| 20 | 64.608 | 74.58 | 60.30 |

**[Table 4]**

| PDF card No. | | Comparative Example 1 CsSnI₃ | Example 1 CsSnI₃ + 15 mol% SnF₂ | Example 2 CsSnI₃ + 20 mol% SnF₂ |
|---|---|---|---|---|
| Cubic 04-014-1735 04-006-8982 | a (Å) | 6.127 | 6.124 | 6.132 |
| | b (Å) | 6.127 | 6.124 | 6.132 |
| | c (Å) | 6.127 | 6.124 | 6.132 |
| | Proportion | 71% | 87% | 0.2% |
| Orthorhombic 01-080-8703 | a (Å) | 8.664 | 8.676 | 8.690 |
| | b (Å) | 12.402 | 12.257 | 12.257 |
| | c (Å) | 8.405 | 8.630 | 8.614 |
| | Proportion | 21% | 13% | 99.8% |
| Orthorhombic 04-014-1737 | a (Å) | 8.662 | - | - |
| | b (Å) | 8.562 | - | - |
| | c (Å) | 12.409 | - | - |
| | Proportion | 8% | 0% | 0% |

According to the results shown in Table 3, Table 4, and FIGS. 7 to 9, addition of 15 mol% SnF₂ to CsSnI₃ resulted in 2θ peak shifts. Additionally, a proportion of a cubic system in the CsSnI₃ crystal is 71% in Comparative Example 1 and 87% in Example 1, the proportion being calculated by the RIR method. This increase indicates increase in crystal symmetry. Furthermore, the following have been found. The ionic radius calculated for the X site from a cubic lattice constant determined by the X-ray diffraction measurement of Example 1 is 2.198 Å, which is slightly smaller than the ionic radius of I⁻, namely, 2.20 Å. The Goldschmidt tolerance factor calculated for Example 1 is 0.8933, which is slightly higher than 0.8932 of CsSnI₃ to which SnF₂ is not added and is nearer to an ideal value, 0.9. These indicate that the addition of SnF₂ caused F⁻ to substitute for I⁻and become a part of the crystalline phase.

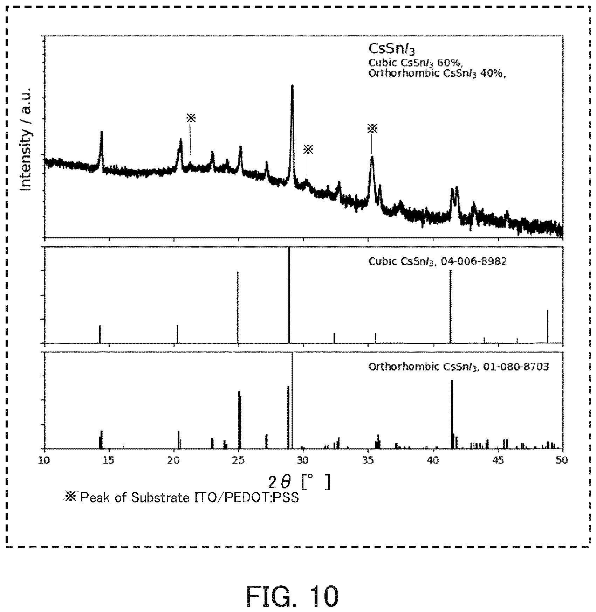

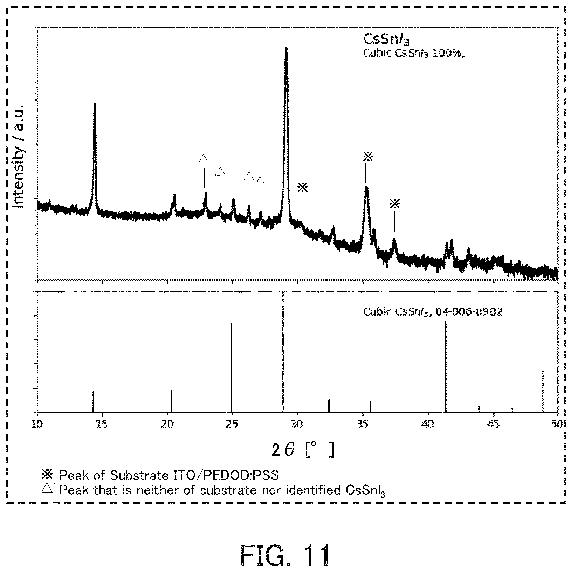

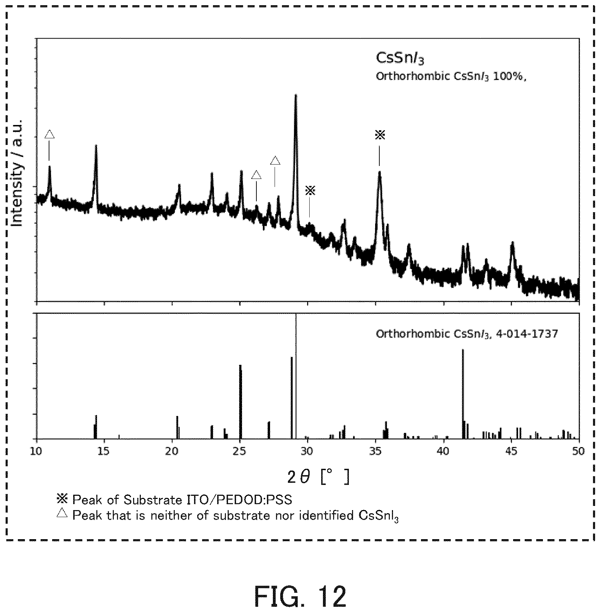

X-ray diffraction measurement using a Cu-Kα ray was performed also for the photoelectric conversion layers of Example 4, Example 5, and Comparative Example 2 in the same manner as for Example 1, Example 2, and Comparative Example 1. Crystal structures were identified by the RIR method using PDXL, the software installed in the X-ray diffractometer. Tables 5 and 6 show the results. Table 5 shows peak positions in X-ray diffraction patterns. The column "No." in Table 5 shows numbers given to the peaks detected by X-ray diffraction in ascending order of angle. The column "PDF card No." in Table 6 shows data numbers of the crystal structures of the identified space groups. Table 6 also shows lattice constants of the analyzed crystals. FIG. 10 is a graph showing the X-ray diffraction pattern of CsSnI₃ being the photoelectric conversion material of Comparative Example 2. FIG. 11 is a graph showing the X-ray diffraction pattern of the photoelectric conversion material of Example 4. FIG. 12 is a graph showing the X-ray diffraction pattern of the photoelectric conversion material of the photoelectric conversion material of Example 5.

**[Table 5]**

| No. | Comparative Example 2 CsSnI₃ [2θ (deg)] | Example 4 CsSnI₃ + 5 mol% SnCl₂ [2θ (deg)] | Example 5 CsSnI₃ + 10 mol% SnCl₂ [2θ (deg)] |
|---|---|---|---|
| 1 | 14.450 | 14.456 | 20.552 |
| 2 | 20.419 | 20.545 | 22.978 |
| 3 | 20.570 | 22.961 | 24.067 |
| 4 | 22.979 | 25.119 | 25.134 |
| 5 | 25.157 | 29.139 | 27.139 |
| 6 | 27.16 | 35.287 | 27.832 |
| 7 | 29.136 | 35.911 | 29.116 |
| 8 | 32.732 | 37.397 | 30.17 |
| 9 | 35.269 | 41.44 | 32.67 |
| 10 | 35.920 | 41.809 | 35.273 |
| 11 | 41.461 | 43.153 | 35.891 |
| 12 | 41.822 | 45.38 | 37.508 |
| 13 | 43.11 | 50.61 | 41.419 |
| 14 | 45.70 | 60.396 | 41.804 |
| 15 | 50.64 | 74.63 | 42.995 |
| 16 | 60.440 | - | 45.06 |
| 17 | - | - | 50.707 |
| 18 | - | - | 55.87 |
| 19 | - | - | 60.30 |
| 20 | - | - | 68.40 |
| 21 | - | - | 74.62 |

**[Table 6]**

| PDF card No. | | Comparative Example 2 CsSnI₃ | Example 4 CsSnI₃ + 5 mol% SnCl₂ | Example 5 CsSnI₃ + 10 mol% SnCl₂ |
|---|---|---|---|---|
| Cubic 04-006-8982 | a (Å) | 6.119 | 6.120 | - |
| | b (Å) | 6.119 | 6.120 | - |
| | c (Å) | 6.119 | 6.120 | - |
| | Proportion | 60% | 100% | 0% |
| Orthorhombic 04-014-1737 | a (Å) | 8.614 | - | 8.688 |
| | b (Å) | 12.360 | - | 8.643 |
| | c (Å) | 8.658 | - | 12.373 |
| | Proportion | 40% | 0% | 100% |

According to the results shown in Table 5, Table 6, and FIGS. 10 to 12, addition of SnCl₂ to CsSnI₃ resulted in 2θ peak shifts. Additionally, a proportion of a cubic system in the CsSnI₃ crystal is 60% in Comparative Example 2 and 100% in Example 4, the proportion being calculated by the RIR method. This increase indicates increase in crystal symmetry. Furthermore, the following have been found. The ionic radius calculated for the X site from a cubic lattice constant determined by the X-ray diffraction measurement of Example 4 is 2.196 Å, which is slightly smaller than the ionic radius of I⁻, namely, 2.20 Å. The Goldschmidt tolerance factor calculated for Example 4 is 0.8934, which is slightly higher than 0.8932 of CsSnI₃ to which SnF₂ is not added and is nearer to an ideal value, 0.9. These indicate that the addition of SnCl₂ caused Cl⁻ to substitute for I⁻ and become a part of the crystalline phase.

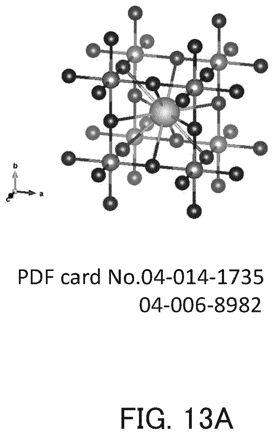

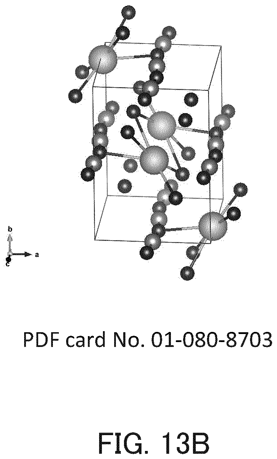

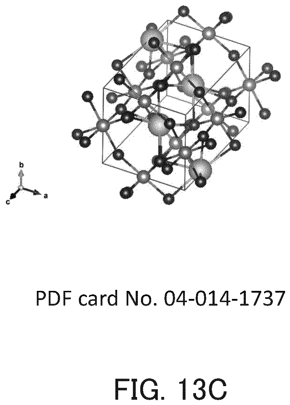

FIG. 13A shows a crystal structure of a cubic crystal included in the photoelectric conversion material of the present disclosure. FIG. 13B shows a crystal structure of an orthorhombic crystal included in the photoelectric conversion material of the present disclosure. FIG. 13C shows a crystal structure of an orthorhombic crystal included in CsSnI₃.

As can be understood from Table 4, the addition of 15 mol% SnF₂ to CsSnI₃ decreased the lattice constants of the identified cubic crystal. This indicates that the SnF₂ caused substitution of F⁻ for part of I⁻. Moreover, the addition of 20 mol% SnF₂ to CsSnI₃ decreased the symmetry of the crystal structure, and thus the crystals mostly became orthorhombic.

According to comparison between Example 1 and Example 2, the volume of the unit lattice of the identified orthorhombic crystal (PDF card No.: 01-080-8703) decreased from 917.76 Å³ to 917.52 Å³. This means that an interatomic distance in the unit lattice of the orthorhombic crystal became shorter; hence it is thought that SnF₂ caused substitution of F⁻ for part of I⁻.

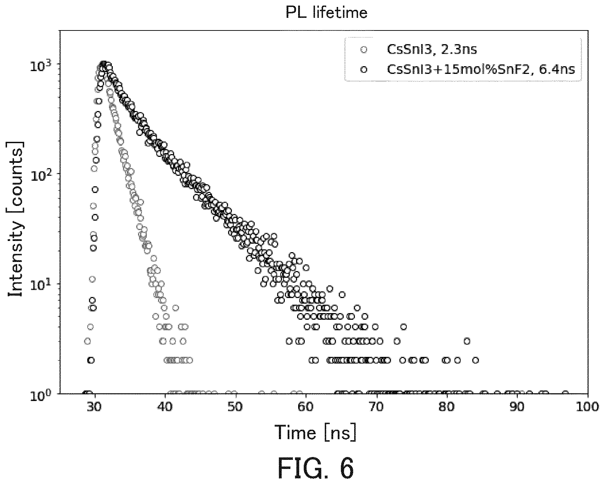

FIG. 6 is a graph showing PL lifetimes of the photoelectric conversion layers alone of Example 1 and Comparative Example 1.

The PL lifetimes were measured using a near-infrared fluorescence lifetime measurement apparatus (C7990 VIS/NIR manufactured by Hamamatsu Photonics K.K.). A photosensor module being one of constituent devices thereof was H7422. The measurement results were analyzed with a fluorescence lifetime software U8167-03.

Measurement samples for the measurement of the PL lifetimes of the photoelectric conversion layers were produced in the same manner as for the photoelectric conversion layers of the photoelectric conversion elements. Specifically, the precursor solution of each photoelectric conversion layer was applied to a bare glass substrate by spin coating, followed by baking at 120°C for 30 minutes to form a single film. The spin coating was performed at 5000 rpm for 30 seconds while chlorobenzene being a poor solvent was supplied dropwise. Next, a UV-curable epoxy resin was applied to a periphery of the substrate, another glass substrate was placed thereon, and the resulting laminate was irradiated with UV. The epoxy resin was thereby cured to encapsulate the measurement sample. The addition of SnF₂ to CsSnI₃ extended the PL lifetime from 2.3 ns to 6.4 ns, which indicates improvement of a carrier diffusion length. It is therefore thought that defects in the crystal of the photoelectric conversion material were reduced.

Measurement samples for measurement by inductively coupled plasma mass spectrometry (ICP-MS) and for measurement by ion chromatography (IC) were produced by the same method as for the photoelectric conversion layers of the photoelectric conversion elements. Specifically, the precursor solution of the photoelectric conversion layer was applied to a bare glass substrate by spin coating, followed by baking at 120°C for 30 minutes to form a single film. Two films of Example 1 in which an amount of SnF₂ actually added to CsSnI₃ was 15 mol% and two films of Example 4 in which an amount of SnCl₂ actually added to CsSnI₃ was 10 mol% were prepared. One of the films of Example 1 and one of the films of Example 4 were each placed in a glass beaker, to which pure water was added to dissolve the film on the substrate. The resulting solution was diluted with pure water to adjust its volume. The solution was then subjected to IC to quantify I and either F or Cl. An analyzer used in the IC was DX-500 manufactured by Dionex Corporation. Hydrochloric acid was later added to a portion of the solution. The resulting solution was diluted with pure water to adjust its volume and was then subjected to ICP-MS to quantify Cs. Agilent-7700 manufactured by Agilent Technologies, Inc. was used for the ICP-MS.

Additionally, the other film of Example 1 and the other film of Example 4 were each placed in a glass beaker, to which hydrochloric acid was added to dissolve the film on the glass substrate. The resulting solution was diluted with pure water to adjust its volume. The solution was then subjected to ICP-MS to quantify Cs and Sn. It was necessary to use a hydrochloric acid solution because dissolving Sn in pure water would cause hydrolysis and generation of Sn(OH)₂. Moreover, a quantitative value of Cs capable of fully dissolving not only in pure water but also in a hydrochloric acid solution was used to calculate a correction factor between the pure-water-based solution and the hydrochloric-acid-based solution. The result of the quantitative determination for Sn in the hydrochloric-acid-based solution was multiplied by the calculated correction factor to determine a quantitative value of Sn in the pure-water-based solution. The quantitative value of Sn and the results of the quantitative determination for Cs, I, F, and Cl in the pure water solution were used to calculate the composition of the crystalline film. Table 7 shows the composition analysis results for the crystalline films in molar ratios where Cs = 1.0. With respect to Cs, amounts of SnF₂ and SnCl₂ detected were close to the amounts of SnF₂ and SnCl₂ actually added.

**[Table 7]**

| | Cs | Sn | I | SnF₂ | SnCl₂ |
|---|---|---|---|---|---|
| CsSnI₃ + 15 mol% SnF₂ | 1.0 | 0.98 | 3.2 | 0.14 | - |
| CsSnI₃ + 10 mol% SnCl₂ | 1.0 | 0.95 | 3.1 | - | 0.10 |

### INDUSTRIAL APPLICABILITY

The photoelectric conversion element of the present disclosure can be included, for example, in solar cells.

## Claims

1. A photoelectric conversion material comprising
a crystalline phase comprising A, B, X, and I, wherein
the A is a monovalent cation and comprises a monovalent inorganic cation,
the B is a divalent cation and comprises Sn,
the X is at least one selected from the group consisting of F, Cl, and Br,
a molar ratio of a sum of the X and I to the B is 2.80 or more and 3.25 or less, and
a molar ratio of the B to the A is more than 1.00 and 1.50 or less.

2. The photoelectric conversion material according to claim 1, wherein the molar ratio of the B to the A is more than 1.00 and less than 1.30.

3. The photoelectric conversion material according to claim 1 or 2, wherein a molar ratio of the X to I is 0.03 or more and 0.19 or less.

4. The photoelectric conversion material according to any one of claims 1 to 3, wherein in an X-ray diffraction pattern obtained by X-ray structure analysis of the crystalline phase using a Cu-Kα ray, peaks are present in diffraction angle 2θ ranges of 25.14° to 25.17° and 29.13° to 29.17°.

5. The photoelectric conversion material according to any one of claims 1 to 4, wherein the crystalline phase has a perovskite structure.

6. The photoelectric conversion material according to any one of claims 1 to 5, wherein
the A further comprises a monovalent organic cation, and
a proportion of an amount of substance of the monovalent inorganic cation to a sum of an amount of substance of the monovalent inorganic cation and an amount of substance of the monovalent organic cation is 5 mol% or more and 30 mol% or less.

7. The photoelectric conversion material according to any one of claims 1 to 5, wherein the A is the monovalent inorganic cation.

8. The photoelectric conversion material according to any one of claims 1 to 7, wherein the monovalent inorganic cation comprises Cs.

9. The photoelectric conversion material according to any one of claims 1 to 8, wherein the X comprises at least one selected from the group consisting of F and Cl.

10. A photoelectric conversion element comprising:
a first electrode;
a photoelectric conversion layer; and
a second electrode, wherein
the photoelectric conversion layer comprises the photoelectric conversion material according to any one of claims 1 to 9.
